# EUROPEAN PATENT APPLICATION

(11) **EP 4 489 532 A1**
(43) Date of publication of application: **08.01.2025**
(21) Application number: 23759966.7
(22) Date of filing: 21.02.2023
(51) Int. Cl.: H05K 3/38, H05K 3/10

(54) **WIRING BOARD**

(30) Priority: 28.02.2022 JP 2022029334
(71) Applicant: Kyocera Corporation, Kyoto-shi, Kyoto 612-8501 (JP)
(72) Inventor: SHIMIZU, Daichi, Kyoto-shi, Kyoto 612-8501 (JP)
(74) Representative: Viering, Jentschura & Partner mbB Patent- und Rechtsanwälte
(86) International application number: PCT/JP2023/006187
(87) International publication number: WO 2023/162965

(57) **Abstract**

A wiring board according to the present disclosure includes an insulation layer having a first surface and a second surface opposite to the first surface, and a first wiring conductor located on the first surface. The first surface of the insulation layer includes a first region having a first arithmetic mean roughness and a second region having a second arithmetic mean roughness. The second arithmetic mean roughness is larger than the first arithmetic mean roughness, and the first wiring conductor is located from the first region to the second region.

## Description

### TECHNICAL FIELD

The present invention relates to a wiring board and a mounting structure using the wiring board.

### BACKGROUND OF INVENTION

In recent years, in wiring patterns formed on wiring boards, fine wiring lines are formed at a high density along with downsizing or the like of electronic devices. Such fine wiring patterns are easily peeled off, and the obtained wiring boards have poor electrical reliability. In order to make the fine wiring patterns less likely to be peeled off, for example, Patent Document 1 discloses that a surface of a resin base material (insulation layer) is roughened to improve adhesion between a wiring pattern and the insulation layer.

### CITATION LIST

### PATENT LITERATURE

Patent Document 1: JP 2007-95828 A

### SUMMARY

### SOLUTION TO PROBLEM

A wiring board according to the present disclosure includes an insulation layer having a first surface and a second surface opposite to the first surface, and a first wiring conductor located on the first surface. The first surface of the insulation layer includes a first region having a first arithmetic mean roughness and a second region having a second arithmetic mean roughness. The second arithmetic mean roughness is larger than the first arithmetic mean roughness, and the first wiring conductor is located from the first region to the second region.

A mounting structure according to the present disclosure includes the above-mentioned wiring board and an element located on a surface of the wiring board.

### BRIEF DESCRIPTION OF THE DRAWINGS

FIG. 1 is an explanatory view for explaining a wiring board according to one embodiment of the present disclosure.
FIG. 2 is an enlarged explanatory view for explaining one embodiment of a cross section of a region X illustrated in FIG. 1.
FIG. 3 is an enlarged explanatory view for explaining another embodiment of a cross section of the region X illustrated in FIG. 1.
FIG. 4 is an enlarged explanatory view for explaining a cross section of a region Y illustrated in FIG. 1.
FIG. 5 is an explanatory view for explaining one embodiment of a method of forming a first region 2a and a second region 2b in an insulation layer (build-up insulation layer).
FIG. 6 is an explanatory view for explaining another embodiment of a method of forming the first region 2a and the second region 2b in the insulation layer (build-up insulation layer).

### DESCRIPTION OF EMBODIMENTS

The conventional wiring board as described in Patent Document 1 allows improved adhesion between the wiring pattern and the insulation layer but has a problem that the electrical characteristics deteriorate when the surface of the insulation layer is roughened. Therefore, a wiring board which has excellent electrical characteristics and in which a wiring conductor is less likely to be peeled off is demanded.

The wiring board according to the present disclosure has a configuration as described in SOLUTION TO PROBLEM, thereby reducing deterioration in electrical characteristics and making the wiring conductor less likely to be peeled off.

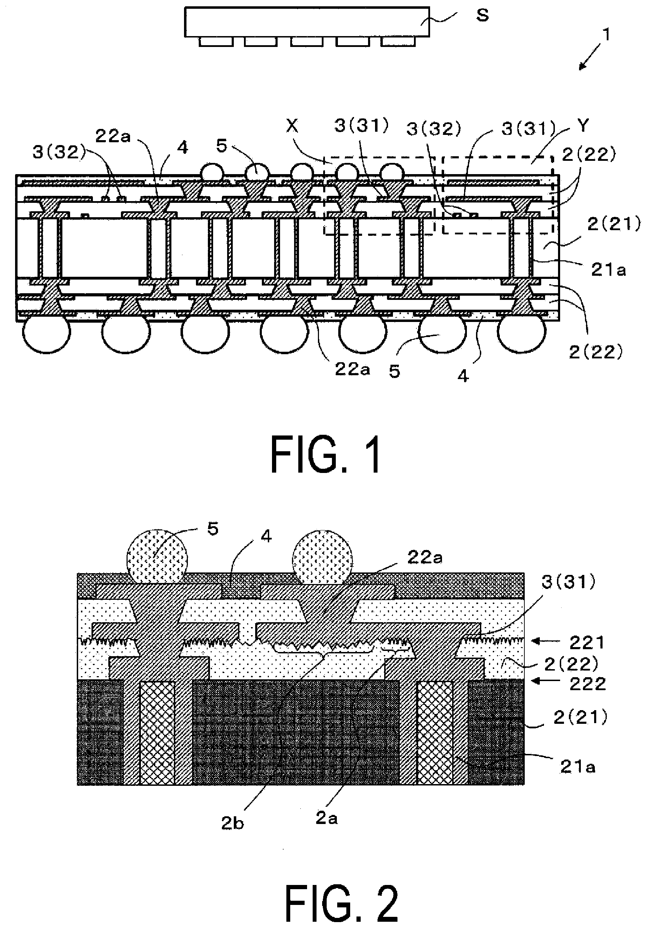

A wiring board according to one embodiment of the present disclosure will be described with reference to FIGs. 1 to 4. FIG. 1 is an explanatory view for explaining a wiring board 1 according to one embodiment of the present disclosure. As illustrated in FIG. 1, a wiring board 1 according to one embodiment includes an insulation layer 2, an electrical conductor layer 3, and a solder resist 4.

The insulation layer 2 includes a core insulation layer 21 and a build-up insulation layer 22. The core insulation layer 21 is not particularly limited as long as it is made of a material having insulation properties. Examples of the material having the insulation properties include resins such as an epoxy resin, a bismaleimide-triazine resin, a polyimide resin, and a polyphenylene ether resin. Two or more types of these resins may be mixed and used. The thickness of the core insulation layer 21 is not particularly limited, and is, for example, 40 µm or more and 1800 µm or less.

The core insulation layer 21 may contain a reinforcing material. Examples of the reinforcing material include insulation fabric materials such as glass fiber, glass non-woven fabric, aramid non-woven fabric, aramid fiber, and polyester fiber. Two or more types of reinforcing materials may be used in combination. An inorganic insulation filler such as silica, barium sulfate, talc, clay, glass, calcium carbonate, or titanium oxide may be dispersed in the core insulation layer 21.

A through-hole conductor 21a is located in the core insulation layer 21 to electrically connect the upper and lower surfaces of the core insulation layer 21. The through-hole conductor 21a is located in the through-hole penetrating from the upper surface to the lower surface of the core insulation layer 21. The through-hole conductor 21a is formed by, for example, metallic plating such as copper-plating. The through-hole conductor 21a is connected to the electrical conductor layer 3 formed on both surfaces of the core insulation layer 21. The through-hole conductor 21a may be located only on the inner wall surface of a through-hole or may be filled in the through-hole.

A build-up layer in which the electrical conductor layer 3 and the build-up insulation layer 22 are alternately layered is located on the upper surface and the lower surface of the core insulation layer 21. In the build-up layer, at least two electrical conductor layers 3 and one build-up insulation layer 22 are layered. The electrical conductor layer 3 is not limited as long as it is made of a conductor such as metal. Specifically, the electrical conductor layer 3 is made of a metal foil such as a copper foil, a metal plating such as a copper plating, or the like. The thickness of the electrical conductor layer 3 is not particularly limited, and is, for example, 10 µm or more and 30 µm or less.

Similarly to the core insulation layer 21, the build-up insulation layer 22 is not particularly limited as long as it is made of a material having insulation properties. Examples of the material having the insulation properties include resins such as an epoxy resin, a bismaleimide-triazine resin, a polyimide resin, and a polyphenylene ether resin. Two or more types of these resins may be mixed and used. Each build-up insulation layer 22 may be made of the same resin or a different resin. The build-up insulation layer 22 and the core insulation layer 21 may be made of the same resin or different resins.

An inorganic insulation filler such as silica, barium sulfate, talc, clay, glass, calcium carbonate, or titanium oxide may be dispersed in the build-up insulation layer 22. The thickness of the build-up insulation layer 22 is not particularly limited and is, for example, 25 µm or more and 40 µm or less. Each build-up insulation layer 22 may have the same thickness or may have a different thickness.

A via-hole conductor 22a for electrically connecting the layers is formed in the build-up insulation layer 22. The via-hole conductor 22a is located in the via hole penetrating through the upper and lower surfaces of the build-up insulation layer 22. The via-hole conductor 22a is formed by, for example, metallic plating such as copper-plating. The via-hole conductor 22a is connected to the electrical conductor layer 3 located on both surfaces of the build-up insulation layer 22. The via-hole conductor 22a may be filled in the via-hole, or may be located only on an inner wall surface of the via-hole.

As illustrated in FIG. 1, the solder resist 4 may be located on the surface of the build-up layer. The solder resist 4 is made of a resin, and examples of the resin include an acrylic-modified epoxy resin. The solder resist 4 is provided with an opening for electrically connecting the electrical conductor layer 3 and an electrode of an element via the solder 5. Examples of the element include a semiconductor integrated circuit element and an optoelectronic element.

As illustrated in FIG. 2, the build-up insulation layer 22 has a first surface 221 and a second surface 222 opposite to the first surface 221. FIG. 2 is an enlarged explanatory view for explaining one embodiment of a cross section of a region X illustrated in FIG. 1. The first surface 221 includes a first region 2a having a first arithmetic mean roughness and a second region 2b having a second arithmetic mean roughness.

In the wiring board 1 according to one embodiment, the second arithmetic mean roughness of the second region 2b is larger than the first arithmetic mean roughness of the first region 2a. In the electrical conductor layer 3, the first wiring conductor 31 is located from the first region 2a to the second region 2b. In this manner, since the first wiring conductor 31 is located in the regions having different arithmetic mean roughnesses, the deterioration of the electrical characteristics in the first region 2a having a small arithmetic mean roughness can be reduced and the adhesion of the first wiring conductor 31 in the second region 2b having a large arithmetic mean roughness can be improved. As a result, in the wiring board 1, deterioration of electrical characteristics is reduced, and the first wiring conductor 31 is less likely to be peeled off.

The electrical conductor layer 3 generally includes a power supply conductor, a ground conductor, and a signal conductor. The first wiring conductor 31 is, for example, a signal conductor. The arithmetic mean roughness (third arithmetic mean roughness) of a side surface of the first wiring conductor 31 and the surface opposite to the surface in contact with the first surface 221 may be smaller than the first arithmetic mean roughness. When the third arithmetic mean roughness is smaller than the first arithmetic mean roughness, the side surface and the surface of the first wiring conductor 31 are relatively flat, which is particularly advantageous in that the transmission characteristics are improved when a high-frequency signal is transmitted.

The second arithmetic mean roughness may be at least 1.5 times the first arithmetic mean roughness. When the second arithmetic mean roughness is at least 1.5 times the first arithmetic mean roughness, a relatively rough region and a smooth region are present, and the adhesion of the first wiring conductor 31 can be further improved while reducing the deterioration of the electrical characteristics. The first arithmetic mean roughness may be, for example, 50 nm or more and 200 nm or less, and the second arithmetic mean roughness may be, for example, 100 nm or more and 300 nm or less.

At least one first region 2a and at least one second region 2b are provided for each first wiring conductor 31. The first region 2a and the second region 2b may be alternately located along the first wiring conductor 31 in consideration of the reduction of the deterioration of the electrical characteristics and the improvement of the adhesion of the first wiring conductor 31.

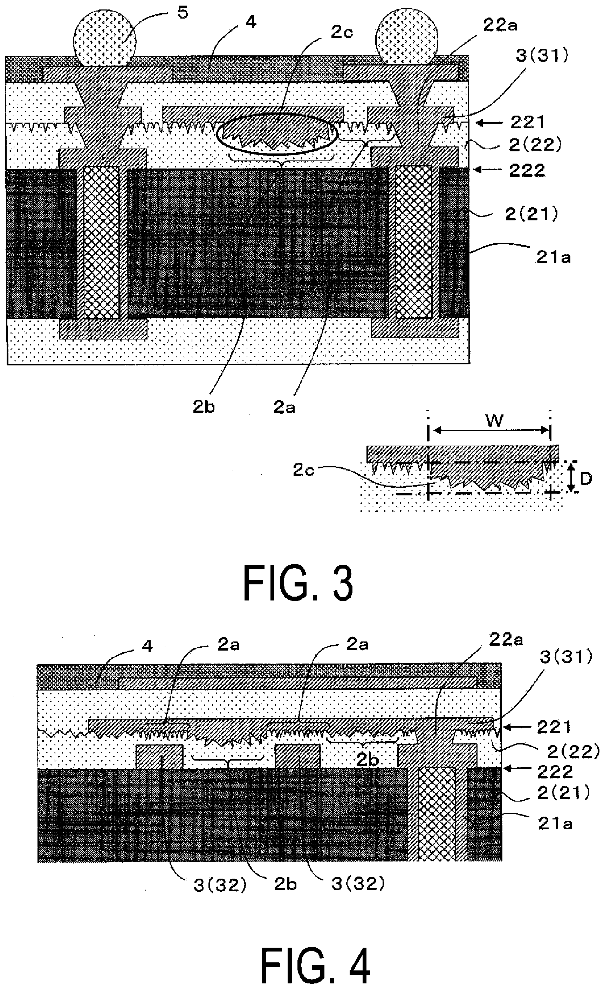

As illustrated in FIG. 3, the second region 2b may have a recessed portion 2c recessed toward the second surface 222. FIG. 3 is an enlarged explanatory view for explaining another embodiment of the cross section of the region X illustrated in FIG. 1. By providing such a recessed portion 2c, the adhesion of the first wiring conductor 31 can be further improved. The arithmetic mean roughness of the recessed portion 2c may be 100 nm or more and 300 nm or less, similarly to the second arithmetic mean roughness of the second region 2b.

The size of the recessed portion 2c is not limited, and for example, the depth (D in FIG. 3) is 5 µm or less at the deepest portion, and the opening width (W in FIG. 3) is 10 µm or more and 200 µm or less at the maximum portion. When the depth D and the opening width W of the recessed portion 2c are in such ranges, the surface of the first wiring conductor 31 (the surface opposite to the recessed portion 2c) can be kept flat. As a result, the adhesion of the first wiring conductor 31 can be further improved without affecting the electrical characteristics.

As illustrated in FIG. 4, the wiring board 1 may include a second wiring conductor 32. FIG. 4 is an enlarged explanatory view for explaining a cross section of a region Y illustrated in FIG. 1. The second wiring conductor 32 is located on the second surface 222 of the build-up insulation layer 22, and is located overlapping the first region 2a of the build-up insulation layer 22 in a plane perspective. In other words, in the present example, the second wiring conductor 32 is located between the build-up insulation layer 22 and the core insulation layer 21 in a state of being partially embedded in the build-up insulation layer 22, and the second wiring conductor 32 is located below the first region 2a in a cross-sectional view. The thickness of the build-up insulation layer 22 located on the upper surface of the second wiring conductor 32 is reduced. Therefore, since the second wiring conductor 32 faces the first region 2a having a small arithmetic mean roughness, the possibility of migration or a short circuit can be reduced, and the deterioration of the electrical characteristics can be reduced. The thickness of the second wiring conductor 32 is, for example, 20 µm or more and 30 µm or less. The distance between the adjacent second wiring conductors 32 is, for example, 30 µm or more and 50 µm or less.

In the wiring board 1 according to one embodiment, the first region 2a and the second region 2b of the insulation layer 2 (build-up insulation layer 22) are formed, for example, as follows. First, in order to layer the insulation layer 2 (build-up insulation layer 22) including the first region 2a and the second region 2b, the insulation layer 2 (for example, the core insulation layer 21) as a base is prepared. The second wiring conductor 32 is formed on the surface of the core insulation layer 21 on which a surface (build-up insulation layer 22) is formed.

Next, the resin sheet 23 to be the build-up insulation layer 22 is layered on the surface of the core insulation layer 21 so as to cover the second wiring conductor 32. The resin sheet 23 to which a protective film 23a is attached is used. The protective film 23a has irregularities on the surface in contact with the resin sheet 23 while being attached to the surface of the resin sheet 23 on the side opposite to the core insulation layer 21. The resin sheet 23 is layered at a relatively high temperature (120°C or higher).

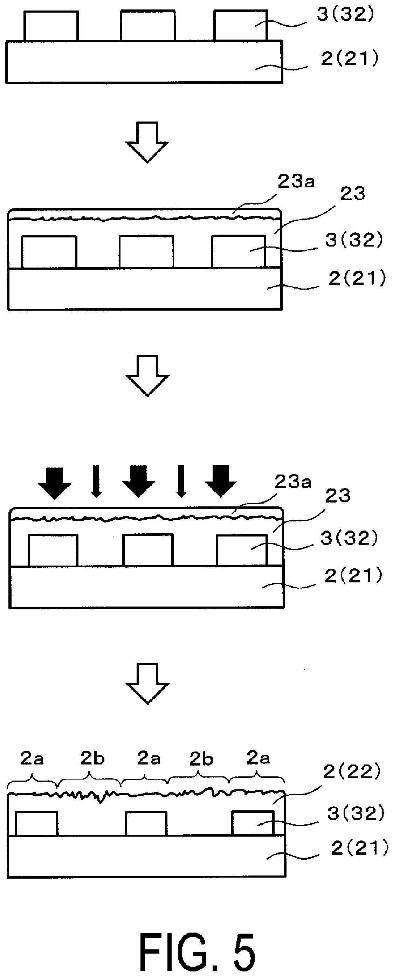

Next, the resin sheet 23 is pressurized from above the protective film 23a. At this time, the portion where the second wiring conductor 32 is present is pressurized more strongly than the other portion with the second wiring conductor 32 serving as a base. After the pressurization, the protective film 23a attached to the resin sheet 23 is peeled off, thereby forming the first region 2a and the second region 2b on the surface (first surface 221) of the build-up insulation layer 22. The portion strongly pressurized with the second wiring conductor 32 serving as a base has a small roughness and becomes the first region 2a. The roughness of the other portion is increased, and as illustrated in FIG. 5, the second region 2b is formed.

The first wiring conductor 31 is formed on the upper surface of the build-up insulation layer 22 from the first region 2a to the second region 2b by a semi-additive method. Next, a metal oxide film such as an oxide film of copper is removed by acid cleaning. Thereafter, tin is precipitated so as to be as thick as 100 nm. Next, excessively precipitated tin is removed, for example, by etching with nitric acid. The etching is performed in this manner to adjust the tin thickness to about 2 nm or more and 5 nm or less.

Next, the silane coupling agent is applied covering the formed tin layer. As the silane coupling agent, a commercially available product such as FC-9100Z (manufactured by MEC COMPANY LTD.), KBM-303 (manufactured by Shin-Etsu Chemical Co., Ltd., or DOWSIL^{™}Z-6040 Silane (manufactured by Dow Toray Co., Ltd.) can be used. After applying the silane coupling agent, treatment is performed at a temperature of 70°C or more and 100°C or less for 1 minute or more and 10 minutes or less, so that a silane coupling agent layer is formed on the surface of the tin layer. In this manner, for example, the first wiring conductor 31 as illustrated in FIG. 1 is formed.

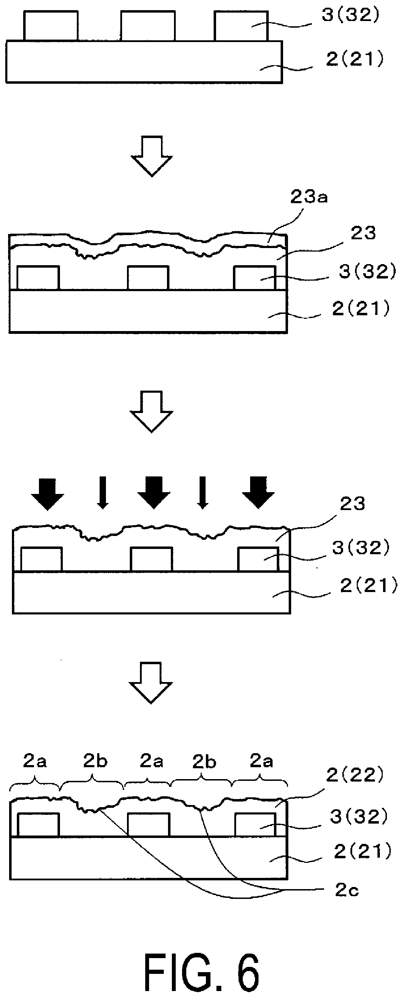

When the resin sheet 23 to be the build-up insulation layer 22 is layered on the surface of the core insulation layer 21 at a relatively low temperature (100°C or less), as illustrated in FIG. 6, a recess is formed in the surface of the resin sheet 23 in a region between the adjacent second wiring conductors 32. After the protective film 23a is peeled off, a release film is interposed on the surface of the resin sheet from which the protective film 23a has been peeled off, and pressure is applied from above the release film. The resin sheet 23 to which the protective film 23a is attached is used. The protective film 23a has irregularities on the surface in contact with the resin sheet 23 while being attached to the surface of the resin sheet 23 on the side opposite to the core insulation layer 21.

At this time, the recessed portion of the surface of the resin sheet 23 is not easily pressurized, and the roughness is likely to increase. On the other hand, the portion where the second wiring conductor 32 exists is strongly pressurized as described above, and the roughness becomes small. By peeling off the release film, the first region 2a and the second region 2b having the recessed portion 2c are formed on the surface (first surface 221) of the build-up insulation layer 22. Due to the presence of the second wiring conductor 32, the recessed portion 2c is easily formed between the adjacent second wiring conductors 32.

A mounting structure according to the present disclosure includes the wiring board 1 according to one embodiment and an element S located on a surface of the wiring board 1. The electrical conductor layer 3 in the opening of the solder resist 4 and the electrode of the element S are connected via the solder 5. As described above, examples of the element S include a semiconductor integrated circuit element and an optoelectronic element. The element S may be located on both surfaces of the wiring board 1, or the element S may be located on one surface of the wiring board 1 and a motherboard, for example, may be located on the other surface thereof.

The wiring board according to the present disclosure is not limited to the wiring board 1 according to the above-described embodiment. In the wiring board 1 according to one embodiment, the build-up insulation layer 22 located directly on the core insulation layer 21 includes the first region 2a and the second region 2b. However, the insulation layer included in the first region 2a and the second region 2b is not limited to the build-up insulation layer 22 located directly on the core insulation layer 21. When two or more build-up insulation layers are present, the first region 2a and the second region 2b may be present on the first surface of the build-up insulation layer 22 other than the build-up insulation layer located directly on the core insulation layer, and the first region 2a and the second region 2b may be present on the first surface of the core insulation layer 21.

In the wiring board according to the present disclosure, the first region 2a and the second region 2b do not need to be present on the first surfaces of all the insulation layers, and the first region 2a and the second region 2b are present on the first surface of at least one insulation layer.

### REFERENCE SIGNS

1 Wiring board
2 Insulation layer
21 Core insulation layer
22 Build-up insulation layer
21a Through-hole conductor
22a Via-hole conductor
221 First surface
222 Second surface
2a First region
2b Second region
2c Recessed portion
23 Resin sheet
23a Protective film
3 Electrical conductor layer
31 First wiring conductor
32 Second wiring conductor
4 Solder resist
5 Solder

## Claims

1. A wiring board comprising:
an insulation layer having a first surface and a second surface opposite to the first surface; and
a first wiring conductor located on the first surface,
wherein the first surface of the insulation layer comprises a first region having a first arithmetic mean roughness and a second region having a second arithmetic mean roughness,
the second arithmetic mean roughness is larger than the first arithmetic mean roughness, and
the first wiring conductor is located from the first region to the second region.

2. The wiring board according to claim 1, wherein
the second region comprises a recessed portion recessed toward the second surface.

3. The wiring board according to claim 1 or 2, further comprising a second wiring conductor located on the second surface,
wherein in a plane perspective, the second wiring conductor is located overlapping the first region.

4. The wiring board according to claim 2, wherein
a depth of the recessed portion is 5 µm or less at a deepest portion.

5. The wiring board according to any one of claims 2 to 4, wherein
in a plan view, an opening width of the recessed portion is 10 µm or more and 200 µm or less at a maximum portion.

6. The wiring board according to any one of claims 1 to 5, wherein
the second arithmetic mean roughness is at least 1.5 times the first arithmetic mean roughness.

7. The wiring board according to any one of claims 1 to 6, wherein
the first region and the second region are alternately located along the first wiring conductor.

8. The wiring board according to any one of claims 1 to 7, wherein
the first wiring conductor is a signal conductor.

9. The wiring board according to any one of claims 1 to 8, wherein
a third arithmetic mean roughness of a side surface of the first wiring conductor and a surface, of the first wiring conductor, located opposite to a surface in contact with the first surface is smaller than the first arithmetic mean roughness.

10. A mounting structure comprising:
the wiring board according to any one of claims 1 to 9; and
an element located on a surface of the wiring board.
